# EUROPEAN PATENT APPLICATION

(11) **EP 4 576 086 A1**
(43) Date of publication of application: **25.06.2025**
(21) Application number: 24179278.7
(22) Date of filing: 31.05.2024
(51) Int. Cl.: G11C 5/04, H01L 21/3065, H01J 37/32, H01L 21/56, H01L 21/683, H01L 23/00

(54) **A METHOD OF PACKAGING SEMICONDUCTOR DIES**

(30) Priority: 20.12.2023 GB 202319607
(71) Applicant: SPTS Technologies Limited, Newport Gwent NP18 2TA (GB)
(72) Inventor: Chard, Liam Andrew John, Newport (GB); Day, Matthew Michael, Newport (GB)
(74) Representative: Wynne-Jones IP Limited

(57) **Abstract**

There is provided a method of packaging semiconductor dies. The method comprises a first step of providing a substrate and a plurality of semiconductor dies interspaced on the substrate, there being an exposed surface of the substrate between the dies. Thereafter, a film is applied to the substrate to cover the plurality of semiconductor dies and the exposed substrate surface with a film layer, wherein each die comprises a top surface and at least one side surface, and wherein the film layer extends across the top surfaces and along the side surfaces of the dies. Subsequently, the film is removed from the top surfaces of the dies, whilst leaving the film intact on the side surfaces of the dies. Thereafter the top surfaces of the dies are plasma etched and the film is removed from the side surfaces of the dies. The semiconductor dies are thinned for use in a variety of end applications.

## Description

### Field

The invention relates to methods of packaging semiconductor dies, for example preparing die assemblies for packaging. The invention also relates to methods of semiconductor die thinning, such methods for example following a die to wafer bonding process. The invention also relates to semiconductor die assemblies for example hybrid bonded semiconductor die assemblies, and plasma etch systems for packaging semiconductor dies, for example, preparing semiconductor dies for packaging and/or performing semiconductor die thinning.

### Background

Thermocompression, fusion and hybrid bonding techniques are used in the fabrication of CMOS image sensors and in advanced packaging applications, for example in preparing semiconductor dies for 3D stacking. In hybrid bonding applications, semiconductor dies of different types or of the same type from different wafers are attached through dielectric to dielectric and metal to metal connections (i.e. bonded) to a substrate, for example a target wafer, so that multiple semiconductor dies can be assembled together in a single package.

Die to wafer bonding is a preferred method of hybrid bonding, as it enables a relatively high placement accuracy of the semiconductor dies, compared to wafer to wafer bonding and other similar techniques. It is also a process which enables a good level of control over the bonded wafer yield as only known good die are selected for bonding. Dies are separated, typically by plasma dicing the wafer through a mask, before being transferred as individual dies supported on a carrier tape in a ring or frame, or on a carrier wafer, to a target wafer already containing dies (which may be of a same or different type).

The limitations of available pick and place tools place restrictions on the size and shape of the semiconductor dies to be transferred. In particular, the dies to be transferred must have a sufficient thickness (i.e. height above the plane of the substrate) to be gripped and moved. Often, end products specify a thinner semiconductor die package, and therefore excess semiconductor die material must be removed to thin (i.e. reduce in thickness) the dies prior to etching.

One solution to the problem is to generate a reconstituted wafer wherein the gaps between the individual dies are filled with a thick dielectric film. While current plasma enhanced chemical vapour deposition (PECVD) SiO₂ films can fill gaps up to about 40µm deep, at least an equivalent amount of SiO₂ will also cover the surface of the dies. Grinding of the SiO₂ and silicon followed by chemical mechanical polishing is required to provide a smooth horizontal top surface of the die. Often the thickness of the dies must be reduced considerably, and consequently the process utilises a large amount of dielectric filler material and is prohibitively expensive.

There is a need for a method of thinning semiconductor dies for example during or after a die to wafer bonding process which retains the integrity of the semiconductor dies and is cost effective in process.

### Summary

In a first aspect of the invention there is provided a method of packaging semiconductor dies. The method comprises a step of providing a substrate and a plurality of semiconductor dies interspaced on the substrate, there being an exposed surface of the substrate between the dies. The method further comprises a step of applying a film to the substrate to cover the plurality of semiconductor dies and the exposed substrate surface with a film layer, wherein each die comprises a top surface and at least one side surface, and wherein the film layer extends across the top surfaces and along the side surfaces of the dies. The method further comprises a step of removing the film from the top surfaces of the dies, whilst leaving the film intact on the side surfaces of the dies. The method further comprises a step of plasma etching the top surfaces of the dies. The method comprises a further step of removing the film from the side surfaces of the dies.

The method advantageously provides a method of packaging semiconductor dies wherein the dies are thinned with high precision. The method as claimed may for example be of particular use following a process of die to wafer bonding on a target wafer in which thicker dies have been required for placement on the target wafer.

Compared to certain methods of the prior art, the claimed method avoids utilising excessive materials such as are required to deposit dielectric layers for grinding. Under the claimed method, the etch of the semiconductor dies is almost perfectly anisotropic in the vertical direction due to the use of the film layer which provides selective passivation of the die side walls during the main etch. The semiconductor die side walls are preserved with high integrity. In applications of the claimed method, an extremely smooth (i.e. having minimal surface roughness ~1nm) horizontal semiconductor top surface is provided. In addition, the present method enables the silicon etch thinning step to be performed at a comparatively high etch rate of approximately 1-10µm/minute, which is comparatively fast compared to methods such as chemical mechanical polishing.

The claimed method of packaging may comprise a method of 3D integration, or 2.5D integration. The method of packaging may comprise a method of semiconductor die thinning of a vertical stack of dies. The method may be repeated for each die which is added to the stack. Alternatively, the method of packaging may comprise a method of semiconductor die thinning of a horizontal stack of dies.

The semiconductor dies may typically be substantially cuboidal in shape. The side surfaces of the semiconductor dies may be essentially vertical with respect to a central horizontal plane of the substrate. The top surfaces of the dies may be substantially horizontal i.e. parallel to the central horizontal plane of the substrate. The exposed surface may be substantially horizontal i.e. parallel to the central horizontal plane of the substrate.

The film may comprises a polymer. Alternatively, the film may comprise another material which has high etch selectivity to the thinning etch process, in other words, it etches much more slowly than the Si, and it can be removed without etching the Si.

The semiconductor dies may comprise unmasked silicon dies.

The film layer may cover the top surfaces of the dies directly without any intervening layer.

The film may be applied by plasma enhanced chemical vapour deposition.

The plasma deposition process may result in a conformal deposition over the dies and the substrate.

The film may be applied using a plasma formed from a fluorocarbon gas.

A fluorocarbon gas may be particularly suitable as a process gas for plasma deposition of a polymer because it forms high quantities of fluorine and carbon and can be easily polymerised.

The fluorocarbon gas may comprise C₄F₈. Alternatively, the fluorocarbon gas may comprise C₅F₈ or C₄F₆ or a mix of the above stated gases.

The film may be applied conformally, in other words having substantially the same thickness everywhere. The film may be applied in at least a vertical and a lateral direction with respect to a central horizontal plane of the substrate in order that the die top surfaces and side surfaces are covered.

The method may further include removing the film from the exposed substrate surface simultaneously with removing the film from the top surfaces of the dies.

The film may be removed from the top surfaces of the dies by anisotropic plasma etching.

"Anisotropic" etching will be understood to mean etching in a direction perpendicular with the exposed surface of the substrate. The film may be removed from the top surfaces of the dies by anisotropic plasma etching in a vertical direction with respect to a central horizontal plane of the substrate. As such the film is removed only where plasma ions contact the semiconductor die assembly in a vertical direction. The high level of directionality ensures that the film remains on the side surfaces of the dies whilst being etched from the top surfaces.

The high level of directionality of the etch may be provided by the generation of a charge bias (i.e. a potential difference) between (i) the semiconductor die assembly together with its surrounding components, and (ii) the plasma. Such a charge bias may be generated by supplying an RF power to at least one supporting component of the semiconductor die assembly (e.g. an electrostatic chuck). The alternating current may cause a negative potential to build on the semiconductor die assembly and the supporting component which then attracts positive ions towards the semiconductor die assembly. To create a suitable charge bias, an RF power i.e. an "RF bias power" may be required to be supplied in excess of 200W, for example in excess of 300W.

The film may be removed from the top surfaces of the dies using a plasma formed from a SF₆ gas.

A SF₆ gas may be particularly suitable as a process gas for plasma etching of a polymer film because it can be used selectively for etching both silicon and a polymer film. As stated above, use of an RF bias power supplied to one or more components supporting the semiconductor die assembly (e.g. an electrostatic chuck) may cause a high level of directionality for plasma etching the polymer film. In addition, use of a comparatively low pressure may minimise the ion collisions to enable a nearly vertical ion bombardment of the semiconductor die assembly.

Alternatively, the plasma may be formed from another gas for example a NF₃ or CF₄ gas.

The film may be removed from the side surfaces of the dies by isotropic plasma ashing. "Isotropic" plasma ashing will be understood to mean not entirely directional. Plasma ashing without any particular directionality may be a particularly effective way to remove all remaining polymer from the semiconductor die assembly.

The film may be removed from the side surfaces of the dies using an oxygen based ashing chemistry, such as O₂ or O₂/Ar.

An oxygen-containing gas is particularly suitable for removing polymer film from the side surfaces of the dies because CO and CO₂ can be formed.

The film layer may be applied over substantially all of the substrate.

The film layer may be applied so that there is no uncovered portion of the substrate or dies.

The film layer may extend along every side surface of the dies.

Accordingly, the film may remain intact on every side surface of the dies whilst the top surfaces of the dies are etched.

The film layer may have a maximum thickness of less than 5µm.

The film layer may have a maximum thickness of less than 2µm, for example less than 1µm.

The film layer may have a substantially constant average thickness, with a maximum variation in thickness from the average thickness of less than 20%.

The maximum variation in thickness may be less than 10%, for example less than 5%.

The film may be applied to the substrate in a single deposition step.

The top surfaces of the dies may be etched until a thickness of each die between the exposed surface of the substrate and the top surface of the die is less than a user-defined threshold thickness.

The threshold thickness may be 20µm.

The threshold thickness may be 10µm.

The threshold thickness may be application specific and may be pre-set by a user before the method is performed, using a controller.

The top surfaces of the dies may be etched using a cyclical etching process for example similar to that described in the Applicant's patent US9842772. A cyclical process may help to maintain a smooth surface and also offer high selectivity to SiO₂ when revealing through silicon vias. Alternatively, the top surfaces of the dies may be etched using a single step process, for example if there is no need to protect buried SiO₂ features.

The top surfaces of the dies may be etched using a plasma formed from a SF₆ gas.

The plurality of semiconductor dies may comprise at least one die of a first type and at least one die of a second type, and the method may include a preceding step of attaching at least one die of the first type to the substrate, wherein at least one die of the second type is pre-bonded on the substrate, to provide the plurality of semiconductor dies interspaced on the substrate. Alternatively, the dies may be of the same type, and bonded onto a target substrate having been selected and removed from different wafers.

The plurality of semiconductor dies may comprise at least one die transported from a first wafer to the substrate and a plurality of further dies supported on the substrate, and the method may include a preceding step of attaching the at least one die to the substrate, wherein the plurality of further dies are pre-bonded on the substrate. The dies may be attached in a stack. The dies may be stacked in a suitable configuration, for example in a vertical stack or in a horizontal stack. A plurality of dynamic random access memory (DRAM) dies may be stacked.

The method may comprise a step of die-to-wafer bonding to provide the substrate and the plurality of semiconductor dies interspaced on the substrate.

The substrate may comprise a semiconductor material.

The substrate may comprise a dielectric material.

The substrate may comprise or be supported on, a tape.

The method may further comprise the subsequent step of applying a packaging material to the substrate to encapsulate the substrate and dies.

The plurality of semiconductor dies may be comprised in a top layer of a plurality of vertical stacks of dies. Alternatively, the plurality of semiconductor dies may be comprised in a plurality of horizontal stacks of dies, wherein the film layer extends across the top surfaces of the dies and along a plurality of outwardly facing side surfaces of the dies (i.e. exposed outer side surfaces).

In a second aspect there is provided a method of semiconductor die thinning. The method comprises a step of applying a continuous film layer over a plurality of unmasked dies supported on a substrate to cover an upper surface and each side surface of the dies. The method comprises a step of plasma etching the film layer to expose the upper surface of each die of the plurality of unmasked dies whilst the film layer remains covering the side surfaces. The method comprises a step of plasma etching the exposed upper surfaces of the dies. The method comprises a step of plasma ashing the film layer remaining on the side surfaces of the dies so that the film layer is entirely removed.

The plurality of unmasked dies may be comprised in a top layer of a plurality of vertical stacks of dies, there being two or more dies in each stack, wherein the continuous film layer covers the upper surfaces of the plurality of unmasked dies in the top layer, and the side surfaces of each die in each stack.

The method may further comprise the steps of: transferring an additional unmasked die to each stack to form a new plurality of unmasked dies comprised in a new top layer; and thereafter: applying a new continuous film layer over the new plurality of unmasked dies, wherein the new continuous film layer covers the upper surfaces of the dies in the new top layer, and the side surfaces of each die in each stack; plasma etching the new film layer to expose the upper surface of each die in the new top layer whilst the new film layer remains covering the side surfaces; plasma etching the exposed upper surfaces of the dies; plasma ashing the new film layer remaining on the side surfaces of the dies so that the new film layer is entirely removed.

In a third aspect of the invention there is provided a semiconductor die assembly comprising a substrate and a plurality of semiconductor dies processed according to the method of the first or second aspect, wherein the plurality of semiconductor dies comprises dies of at least two different types bonded to the substrate.

In a fourth aspect of the invention there is provided a semiconductor die assembly comprising a substrate and a plurality of semiconductor dies processed according to the method of the first or second aspect, wherein the plurality of semiconductor dies each have a thickness of less than 15µm.

In a fifth aspect of the invention there is provided a plasma etch apparatus configured to perform a method according to the first or second aspect. The plasma etch apparatus comprises a chamber. The plasma etch apparatus further comprises a plasma generator associated with the chamber and configured to generate a plasma from at least one gas received in the chamber. The plasma etch apparatus further comprises a substrate support configured to support a substrate assembly comprising a substrate and a plurality of semiconductor dies interspaced on the substrate, the substrate support being arranged with respect to the chamber such that in use, the plasma contacts the substrate assembly. The plasma etch apparatus further comprises a controller configured to cause the apparatus to undertake a plasma deposition to cover the substrate assembly with a film layer, and subsequently to undertake a plasma etch to partially remove the film layer so that a top surface of the semiconductor dies is exposed, and subsequently to undertake a plasma etch to reduce in thickness the plurality of semiconductor dies, and subsequently to undertake a plasma ash to fully remove the film layer.

### Drawings

An embodiment of the present invention will now be described by way of example only with reference to the accompanying schematic drawings:
Figure 1 is a side view of a semiconductor die assembly prior to die thinning, according to the example embodiment of the invention;
Figure 2 is a side view of the semiconductor die assembly of Figure 1 after film deposition;
Figure 3 is a side view of the semiconductor die assembly of Figures 1 and 2 after partial etching of the film;
Figure 4 is a side view of the semiconductor die assembly of Figures 1-3 after etching of the dies;
Figure 5 is a side view of the semiconductor die assembly of Figures 1-4 after full etching of the film;
Figure 6 is a flow diagram of a method of die thinning in accordance with the example embodiment of the invention;
Figure 7 is a side view of the semiconductor die assembly of Figure 4 in which the polymer layer on the side walls has partially collapsed;
Figure 8 is a side view of a plasma etch apparatus for performing the method of Figure 6.

### Detailed description

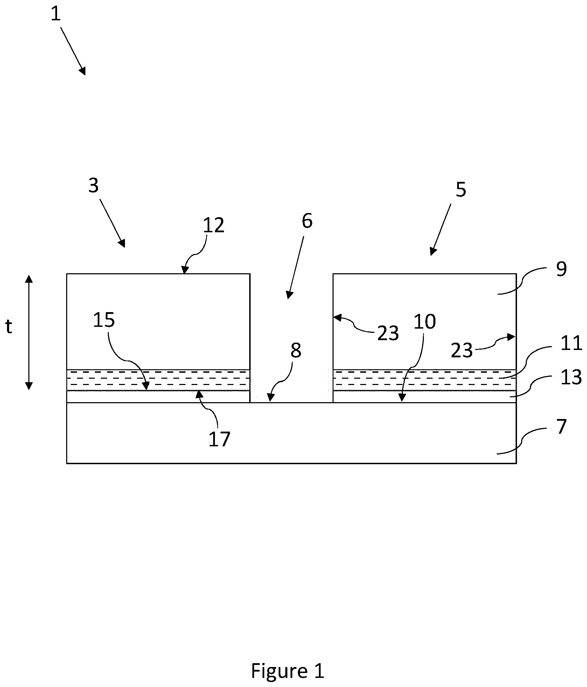

In the example embodiment of the invention there is provided a semiconductor die assembly 1 comprising two semiconductor dies 3, 5 positioned side by side and bonded to a substrate 7 (Figure 1). For the purposes of illustration, the assembly 1 comprises two dies, however in other embodiments there may be a plurality of dies, for example in excess of 50 or in excess of 100 dies attached to a substrate. The dies are positioned on the substrate 7 with a gap 6 between the dies such that a portion 8 of the upper surface 10 of the substrate 7 is exposed ("exposed portion 8"). In embodiments wherein there are more than two dies, the dies may be arranged evenly across the substrate. In the present embodiment the substrate 7 is unsupported. In alternative embodiments the substrate 7 may be supported on a support structure, for example a film in a frame or a base wafer.

In the example embodiment the substrate 7 comprises a 300mm wafer. In an alternative embodiment the substrate may instead comprise a tape (i.e. the dies are on a tape). In the example embodiment, the dies are square in a top view, and have four side surfaces 23. Each die 3, 5 comprises a semiconductor layer 9, in the example embodiment formed of silicon, above a dielectric layer 11. The dielectric layer 11 of each die 3, 5 makes contact with an interface layer 13 on the wafer 7. In the example embodiment of the invention, the dielectric layer 11 of each die comprises a lower dielectric surface 15 which incorporates bond pad openings (not shown) for hybrid bonding the dies 3, 5 to an upper interface surface 17 of the interface layer 13 of the wafer 7.

The dies 3, 5 of the semiconductor die assembly 1 have been attached to the wafer 7 following a die to wafer bonding process using pick and place robots (not shown). The dies 3, 5 each have a thickness t of approximately 40µm between a top surface 12 of the die and the upper interface surface 17 of the interface layer 13 of the wafer 7. The pick and place process and machinery is known in the art and not described in detail herein. In order for accurate placement by a pick and place robot, a die thickness of approximately 30µm or more is required. However, a significantly smaller thickness is desired for many applications for practical reasons, for example to enable integration in a variety of end products having differing space constraints, and for reasons of economy. A slight, or a substantial, thickness reduction may be required, depending on the intended end use.

In order to thin the dies 3, 5, a method of die thinning is undertaken as described herein.

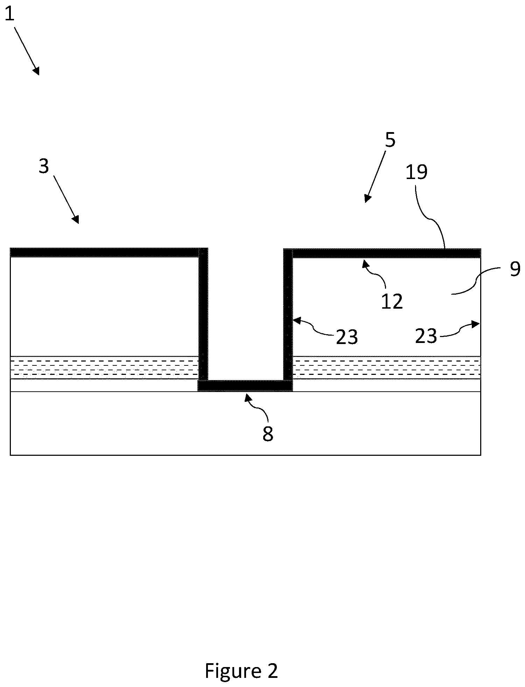

In an initial step 103, the dies 3, 5 and wafer 7 are covered with a film layer 19 (Figure 2). The film layer provides a passivation layer i.e. a protective layer covering the surfaces of each silicon die 3, 5. In the example embodiment the film layer 19 comprises a polymer formed from fluorine and carbon, however other passivation materials for example other polymer materials may be suitable as alternatives. In the example embodiment the film layer 19 is deposited by plasma deposition using an inductively-coupled plasma (ICP) etch apparatus known in the art. Another etch apparatus may be suitable as an alternative, for example a PECVD chamber or a RIE chamber. The apparatus (as is described in more detail below) generates a plasma from a fluorocarbon gas, for example C₄F₈. The plasma deposition is undertaken over a period of approximately 40-80 seconds, in a secondary/ main chamber of the apparatus at a relatively high pressure of around 80-120mTorr (the apparatus being described in more detail below). The apparatus of the example embodiment receives two C₄F₈ gas flows (i.e. primary and secondary gas flows) into the chamber via two separate inlets. The gas is fed at a flow rate of approximately 100-300sccm. In an alternative embodiment a single chamber of a similar apparatus may be fed with a single gas supply. In the example embodiment, two plasma generators in the form of ICP sources generate two plasmas (which subsequently mix) from the two respective gas feeds by electromagnetic induction at an ICP power of approximately 500-2000W.

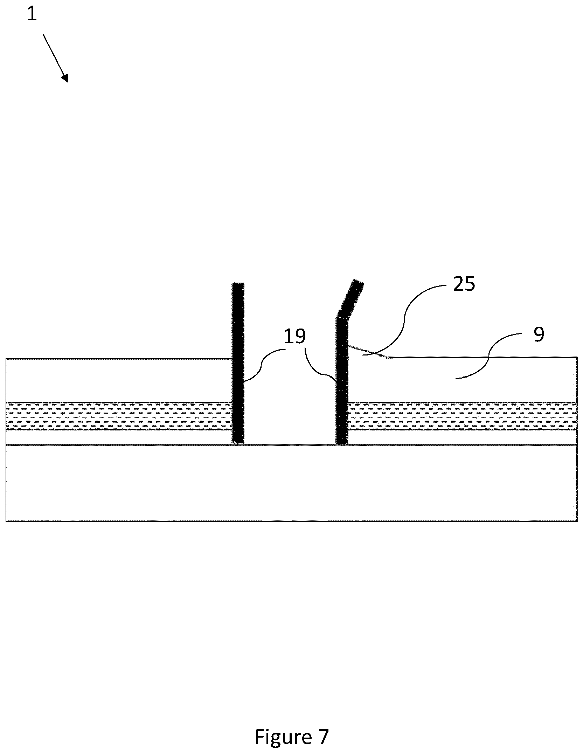

An AC voltage of 13.56MHz (i.e. a high frequency "RF bias power") is applied to a supporting component of the semiconductor die assembly 1 (as described in more detail with reference to Fig. 7 below). On the positive cycle electrons are attracted to the supporting component and on the negative cycle cations are attracted to the supporting component however, since electrons travel faster, a negative DC potential builds up on the supporting component. This creates a charge bias (i.e. charge differential / potential difference) between the semiconductor die assembly 1 and the plasma. The negative DC potential then attracts cations to the semiconductor die assembly 1 on the supporting component, which are deposited as a carbon and fluorine containing polymer layer 19. Use of a relatively high pressure results in scattering which helps to make the deposition more uniform.

By applying an RF bias power to the supporting component, the charge differential can be controlled which in turn controls the rate of polymer deposition. An RF bias power of approximately 450-550W has been found to be suitable for polymer deposition.

The polymer layer 19 is deposited to a thickness of approximately 1µm (not shown to scale) and is applied as a substantially uniform layer i.e. having a substantially constant thickness across the semiconductor die assembly 1. The high pressure deposition step is isotropic, with the positively charged plasma ions flowing towards all outer surfaces of the semiconductor die assembly 1 as part of the flow through of the plasma within the chamber. The polymer layer 19 is deposited in a single application. A thickness of between 0.5-1.5µm has been found to be optimal for providing a film layer which is sufficiently thick to successfully passivate the sides of the semiconductor layer during plasma etching, whilst sufficiently thin that it can be applied in a single application.

The polymer layer 19 covers each die entirely and also completely covers the exposed portion 8 of the upper surface 10 of the substrate 7. The polymer layer thus provides a continuous passivation layer covering the die assembly. In an embodiment wherein there are a plurality of dies attached to a substrate, the exposed portion may comprise several smaller exposed portions of an upper surface of the substrate between and around the dies.

In the example embodiment, the polymer layer 19 extends across the entirety of the top surface 12 of each die and along each side surface 23 of each die 3, 5. The thickness of the polymer layer 19 across the top surfaces 12 of the dies 3, 5 is substantially the same as the thickness of the polymer layer 19 along the side surfaces 23 of the dies 3, 5 and substantially the same as the thickness of the polymer layer 19 across the exposed portion 8 of the upper surface 10 of the substrate 7. In an alternative embodiment, the thickness of the polymer layer 19 along the side surfaces 23 may be slightly less than the thickness of the polymer layer 19 across the top surface 12 of the die 3, 5 and/or the exposed portion 8 of the upper surface 10 of the substrate 7. A passivation effect is nevertheless still provided as long as the polymer layer provides a continuous barrier (i.e. having no gaps).

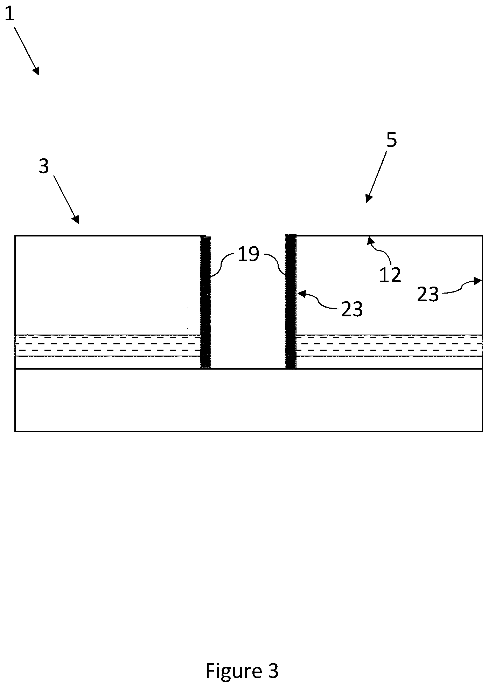

In a subsequent step, the polymer layer 19 is removed from the top surface 12 of each die 3, 5 and the exposed portion 8 between the dies 3, 5 whilst leaving the polymer layer 19 intact on the side surfaces 23 of the dies (Figure 3). Thus, the side surfaces of the dies remain passivated whilst the top surface 12 of the dies is exposed. In the example embodiment the polymer layer 19 is removed by plasma etching using the same plasma etch apparatus. The apparatus (as is described in more detail below) generates a plasma from a SF₆ gas. The polymer plasma etch is undertaken over a period of approximately 120-160 seconds, in a chamber of the apparatus at a relatively low pressure of around 5-20mTorr. Dual input SF₆ gas flows (i.e. primary and secondary gas flows) are fed into the chamber at a low flow rate of approximately 150-250sccm. Dual ICP plasma sources generate two plasmas which subsequently mix by electromagnetic induction at an ICP power of approximately 500-2000W. An RF bias power of approximately 250-350W has been found to be suitable for the polymer etch.

In the example embodiment, the etch of the polymer from the die top surfaces 12 and the exposed portion 8 between the dies 3, 5 is simultaneous, with the etch being directional along a vertical axis i.e. an axis perpendicular to a central horizontal plane of the substrate 7. Since the etch is directional/ anisotropic, the polymer on the side surfaces 23 of the dies is unaffected and remains in place. The directionality is achieved by using SF₆ gas at a low pressure with an RF bias power during etching. In contrast, the deposition of the film uses a C₄F₈ gas at a high pressure, with an RF bias power.

The polymer layer removal from the die top surfaces is monitored by spectroscopy and continues until a spectral line at 300nm drops suddenly and sharply before levelling off to indicate that the horizontal top surfaces of the die have been cleared of polymer (and by implication the layer is also thus removed from the exposed portion 8).

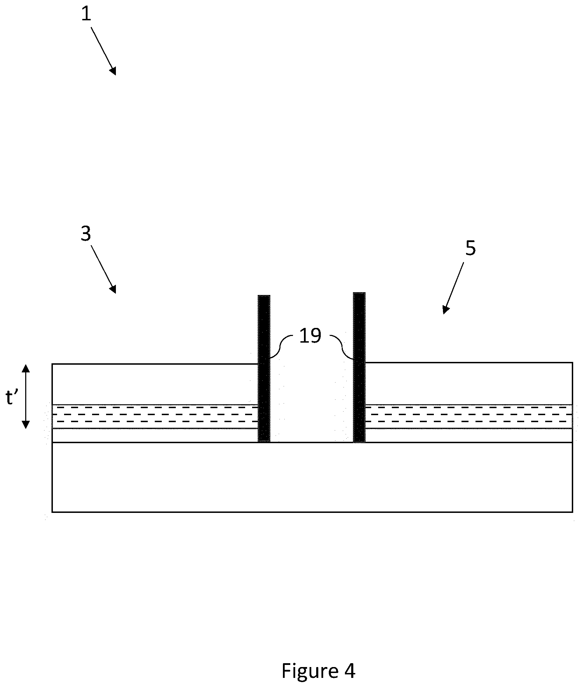

In a subsequent step, the top surface 12 of the silicon dies 3, 5 is plasma etched to thin the dies (Figure 4). In the example embodiment the dies are thinned by plasma etching using the same plasma etch apparatus as has been used for polymer deposition and polymer etching (although in principle the polymer layer could be deposited in another tool post dicing). Similar to the polymer etch of the die top surfaces, the apparatus chamber is dual fed with a SF₆ gas. The etch rate of the Si die is faster than the etch rate of the polymer layer, which means that the dies can be thinned whilst the polymer layer remains intact on the die sidewalls. The Si etch step uses a higher SF₆ flow rate of approximately 500-1000sccm and a slightly higher pressure to increase the etch rate.

In the example embodiment of the invention, there are buried features in the form of through silicon vias (TSVs - not shown in the figures) in the semiconductor layer 9 of the dies. The TSVs comprise Cu pillars covered by a dielectric layer of SiO₂. The Si plasma etching is undertaken cyclically (to increase SiO₂ selectivity), at a low-moderate pressure of around 20-40mTorr. The etch is performed over an alternating sequence in which an RF bias power is applied for one second, and then removed (i.e. the RF bias power is off) for two seconds. The process continues until a target silicon thickness t' is achieved wherein the etch ends on a smooth Si surface (although alternatively the etch could end when the TSVs are exposed). During the etching, the film layer 19 which remains on the side surfaces 23 of the dies 3, 5, protects the sides of the dies 3, 5 from unwanted etching. As such, the plasma etch of the silicon is anisotropic, by virtue of the protective passivation layer. In other words, the etch is directional in the vertical direction. The reduction in thickness achieved can vary according to requirements from a reduction of a few microns, to tens or hundreds of microns. In an alternative embodiment without TSVs or other buried features, a cyclical etching process may be omitted in favour of a single step process, as SiO2 selectivity is not of particular concern.

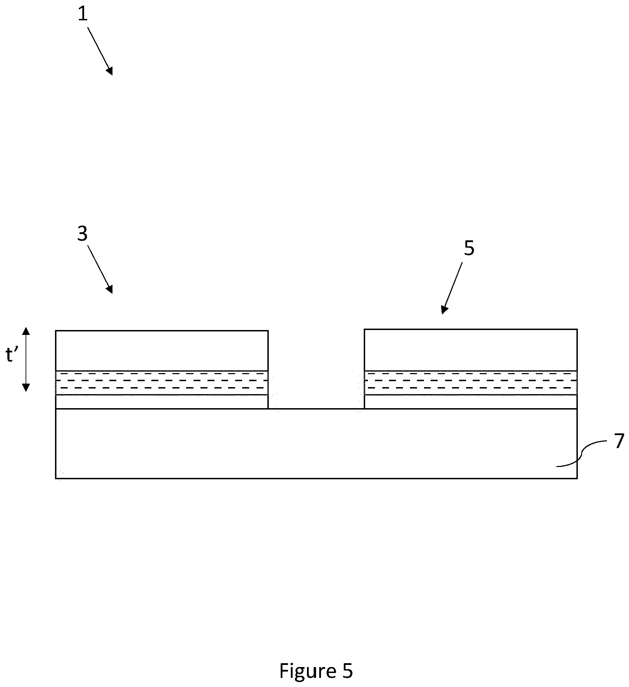

In a subsequent step, the polymer layer 19 is removed from the side surfaces 23 of each die 3, 5 so that the polymer is entirely removed from the semiconductor die assembly 1 leaving the thinned dies 3, 5 bonded to the wafer 7 (Figure 5). In the example embodiment the polymer layer 19 is removed from the side surfaces 23 by plasma ashing using the same plasma etch apparatus. The apparatus (as is described in more detail below) generates a plasma from an oxygen-containing gas. The plasma ashing is undertaken in a chamber of the apparatus at a relatively low pressure of around 5-15mTorr. Dual input oxygen containing gas flows (i.e. primary and secondary gas flows) are fed into the chamber at a flow rate of approximately 100-400sccm. Dual ICP plasma sources generate the plasmas which subsequently mix by electromagnetic induction at an ICP power of approximately 2-5kW. A low RF bias power of approximately 0-50W has been found to be suitable for the polymer ashing. An anisotropic ash is performed and all remaining polymer is removed.

The final polymer strip is timed, but could in another embodiment be monitored using an optical end point signal.

In the example embodiment, the semiconductor die assembly is held at a constant temperature, for example of around 1-10 degrees C for the deposition and etching steps and slightly hotter (due to a higher ICP power) but less than 50 degrees C for the ashing step.

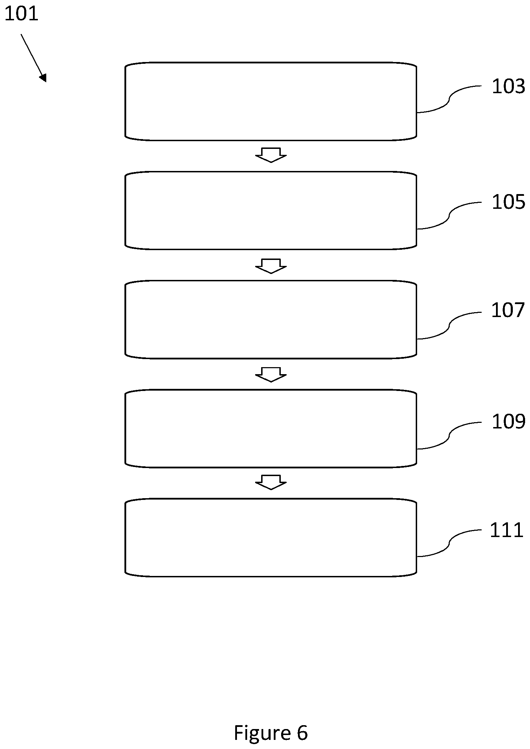

The method of die thinning as described provides a more compact semiconductor die assembly and prepares the dies 3, 5, for packaging for example using advanced packaging techniques. In summary (Figure 6), the method comprises a first step 103 of providing a semiconductor die assembly; a second step 105 of applying a film to the substrate 7 to cover the semiconductor dies and the exposed portion 8 with a film layer, wherein the film layer extends across the top surfaces and along the side surfaces of the dies; a third step 107 of removing the film from the top surfaces of the dies, whilst leaving the film intact on the side surfaces of the dies; a fourth step 109 of plasma etching the top surfaces of the dies; and a fifth step 111 of removing the film from the side surfaces of the dies. Thus a processed die assembly is provided having dies which are thinned from their original thickness of approximately 40µm thick, to a height suitable for packaging for a variety of end applications, for example to half the original height or less, for example to one quarter of the original height or less.

The process may be tuned as required. In some circumstances the film layer 19 on the side surfaces of the dies can become partially collapsed during the Si etch (Figure 7). When the film layer collapses over the semiconductor layer 9, the semiconductor layer is partially obscured in a top view, and the Si etch rate is reduced in the vicinity of the obscured region 25. Consequently Si thickness adjacent the film layer is greater than on open areas of the die. To avoid this occurrence, the film deposition and semiconductor layer and film etch parameters may be varied. Alternatively or additionally the method can include an additional step of stripping and redepositing the film layer as an intermediate step.

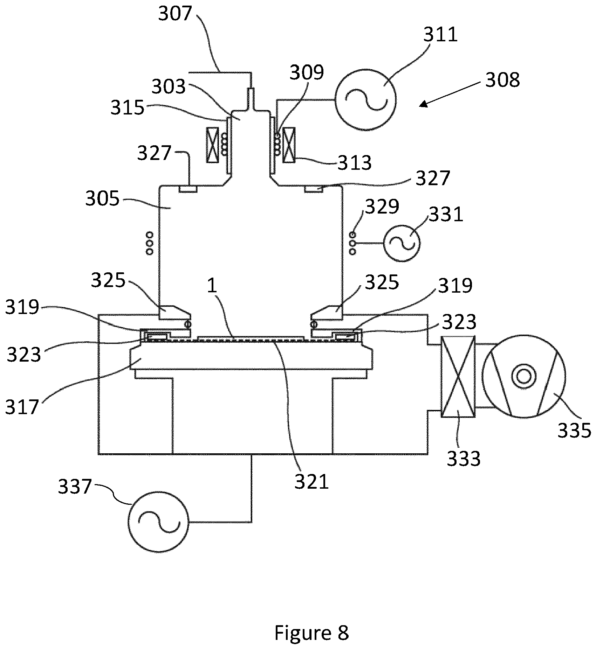

In the example embodiment, all of the method steps are carried out using a plasma etch apparatus 301 such as the Rapier XE ^{™} (Figure 8). In an alternative embodiment, the method steps may be undertaken using separate modules on a cluster tool, or using a series of distinct tools or other apparatus.

The plasma etch apparatus 301 comprises a first chamber 303 disposed above a second larger chamber 305. A first plasma generator 308 in the form of a cylindrical ICP source 309 connected to a first RF (13.56MHz) power supply 311, is arranged at the periphery of the first chamber, and configured to excite electrons in a gas within the first chamber by generating varying magnetic fields to induce electric fields. A first gas inlet 307 feeds a first process gas into the first chamber 303, wherein a primary plasma is generated through electromagnetic induction followed by ion generation.

A DC coil 313 is used to control the shape of the plasma leaving the first chamber 303. A faraday shield 315 reduces capacitive coupling from the ICP source, i.e. making it predominantly inductive.

The plasma flows into the second chamber 305 where it contacts the semiconductor die assembly 1 supported on an electrostatic chuck 317. The semiconductor die assembly 1 is carried on a tape 321 held in a frame 323. In the example embodiment, the edge of the semiconductor die assembly 1 is protected by a wafer edge protection (WEP) device 319. A baffle 325 above the electrostatic chunk 317 is arranged to control gas flow in the vicinity of the semiconductor die assembly.

A second gas inlet 327 is disposed in an annular arrangement at the top of the second chamber 305, and arranged to feed a second process gas into the second chamber. A second plasma generator 329 connected to a second RF (13.56MHz) power supply 331 provides a second cylindrical ICP source. A coaxial source helps to increase the etch rate towards the edge of the semiconductor die assembly. The second plasma generator 329 is arranged at the periphery of the second chamber, and configured to generate a secondary plasma from the second process gas at the periphery of the second chamber 305. The two plasmas mix in the chamber and provide a more evenly distributed plasma over the semiconductor die assembly. The flow of the gas through the chambers is assisted by a pump 335 and valve 333. A separate power supply 337 (also at 13.56MHz although frequencies of 2-20MHz could be used) provides an RF bias power on the electrode i.e. support associated with the semiconductor die assembly.

## Claims

1. A method of packaging semiconductor dies comprising the steps of:
providing a substrate and a plurality of semiconductor dies interspaced on the substrate, there being an exposed surface of the substrate between the dies;
applying a film to the substrate to cover the plurality of semiconductor dies and the exposed substrate surface with a film layer, wherein each die comprises a top surface and at least one side surface, and wherein the film layer extends across the top surfaces and along the side surfaces of the dies;
removing the film from the top surfaces of the dies, whilst leaving the film intact on the side surfaces of the dies;
plasma etching the top surfaces of the dies;
removing the film from the side surfaces of the dies.

2. A method according to claim 1, wherein the film comprises a polymer.

3. A method according to claim 1 or 2, wherein the semiconductor dies comprise unmasked silicon dies.

4. A method according to any preceding claim, wherein the film is applied by plasma enhanced chemical vapour deposition .

5. A method according to any preceding claim, wherein the film is applied using a plasma formed from a fluorocarbon gas.

6. A method according to any preceding claim, further including removing the film from the exposed substrate surface simultaneously with removing the film from the top surfaces of the dies.

7. A method according to any preceding claim, wherein the film is removed from the top surfaces of the dies using a plasma formed from a SF₆ gas.

8. A method according to any preceding claim, wherein the film is removed from the side surfaces of the dies by isotropic plasma ashing.

9. A method according to any preceding claim, wherein the film is removed from the side surfaces of the dies using an oxygen based ashing chemistry.

10. A method according to any preceding claim, wherein the film layer has a maximum thickness of less than 5µm.

11. A method according to any preceding claim, wherein the film is applied to the substrate in a single deposition step.

12. A method according to any preceding claim, wherein the top surfaces of the dies are etched until a thickness of each die between the exposed surface of the substrate and the top surface of the die is less than a user-defined threshold thickness.

13. A semiconductor die assembly comprising a substrate and a plurality of semiconductor dies processed according to the method of any of claims 1-12, wherein the plurality of semiconductor dies comprises dies of at least two different types bonded to the substrate.

14. A semiconductor die assembly comprising a substrate and a plurality of semiconductor dies processed according to the method of any of claims 1-12, wherein the plurality of semiconductor dies each have a thickness of less than 15µm.

15. A plasma etch apparatus configured to perform a method according to any of claims 1-12, the plasma etch apparatus comprising:
a chamber;
a plasma generator associated with the chamber and configured to generate a plasma from at least one gas received in the chamber;
a substrate support configured to support a substrate assembly comprising a substrate and a plurality of semiconductor dies interspaced on the substrate, the substrate support being arranged with respect to the chamber such that in use, the plasma contacts the substrate assembly; and
a controller configured to cause the apparatus to undertake a plasma deposition to cover the substrate assembly with a film layer, and subsequently to undertake a plasma etch to partially remove the film layer so that a top surface of the semiconductor dies is exposed, and subsequently to undertake a plasma etch to reduce in thickness the plurality of semiconductor dies, and subsequently to undertake a plasma ash to fully remove the film layer.
